# EUROPEAN PATENT SPECIFICATION

(11) **EP 0 764 952 B1**
(45) Date of publication and mention of the grant of the patent: **05.02.2003**
(21) Application number: 96305453.1
(22) Date of filing: 25.07.1996
(51) Int. Cl.: G11C 11/409, G11C 7/00

(54) **An apparatus and method for a data path implemented using non-differential current mode techniques**
Anordnung und Verfahren zur Ausführung eines Datenpfads mit Gebrauch von nicht differentieller Strommodustechnik
Appareil et méthode d'implementation d'imbus de donnée utilisant des techniques de mode de courant non différentiel

(43) Date of publication of application: 26.03.1997
(60) Divisional application: 02102037.5
(73) Proprietor: TEXAS INSTRUMENTS INCORPORATED, Dallas, Texas 75243 (US)
(72) Inventor: Haukness, Brent S., Garland, TX 75044 (US)
(74) Representative: Holt, Michael

(56) References cited:
- EP-A- 0 353 508
- US-A- 4 797 583
- US-A- 5 262 984

## Description

### TECHNICAL FIELD OF THE INVENTION

This invention relates generally to dynamic random access memory (DRAM) units and, more particularly, to the signal paths which couple the local input/output (I/O) devices and the storage cells in dynamic semiconductor memories.

### DESCRIPTION OF THE RELATED ART

In order to increase the speed of DRAM units, the use of current-mode techniques, as opposed to voltage mode techniques have been proposed to minimize the effect of parasitic capacitance over long data lines. However, typical current-mode circuits are implemented using differential circuit techniques. While the differential techniques have the advantage that the two interconnect lines simplify the detection of the signal, the two interconnect lines provide an undesirable increase in the area required to implement the signal path on the semiconductor chip. One such circuit is disclosed in US Patent No. 4,797,593 by Mashiro Ueno et al, and entitled "Level Converting Circuit for Converting Voltage Levels, including a Current Amplifying Arrangement."

A need has therefore been felt for apparatus and an associated technique which can take advantage of the increased speed of the current-mode techniques without incurring the penalty of increased implementing area.

### SUMMARY OF THE INVENTION

The aforementioned and other features are accomplished, according to the present invention, by apparatus for converting the differential output signals from the sense amplifiers of a dynamic random access memory unit to a non-differential current mode signal. The current mode signal is applied to a data line. The non-differential current mode signal transmitted by the data line is applied to apparatus which converts the current mode signal first to a small swing voltage signal and then to a large swing voltage signal suitable for use with circuits coupled to the dynamic random access memory unit. To convert the small swing voltage signal to a large swing voltage signal, sample and hold apparatus stores a reference signal against which the small swing voltage signal is compared. The comparison of the reference signal and the small voltage signal determined by the logic state detected by the sense amplifiers generates a full voltage swing output signal.

### BRIEF DESCRIPTION OF THE DRAWINGS

The present invention will now be further described, by way of example with reference to the accompanying drawings in which;
Figure 1 is a block diagram of the data path non-differential current mode apparatus of the present invention;
Figure 2 is a schematic circuit diagram of the data path non-differential current mode apparatus of the present invention;
Figure 3 illustrates a simulated READ '0' transition for the present invention; and
Figure 4 illustrates a simulated READ '1' transition for the present invention.

### DESCRIPTION OF THE PREFERRED EMBODIMENTS

### DETAILED DESCRIPTION OF THE DRAWINGS

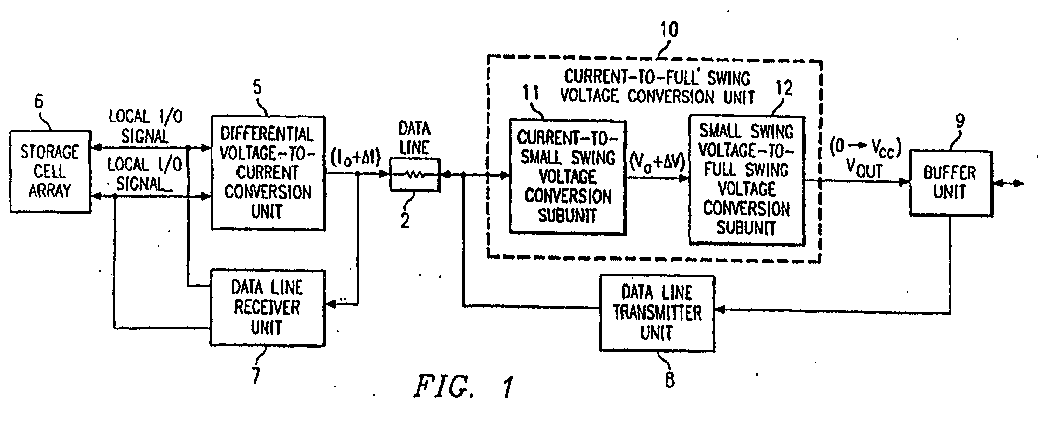

Referring now to Fig. 1, a block diagram of the non-differential, current mode data path, according to the present invention, along with associated memory components of a memory unit, for retrieving data from a storage cell array is shown. The local input/output signal (LOCAL I/O SIGNAL) and the logical complement (LOCAL I/O SIGNAL_), both from the storage cell array 6 is applied to the differential voltage-to-current conversion unit 5. The output signal (I_{O} ± DELTA I) from the differential signal-to-current conversion unit is applied through the data line 2 to the current-to-small swing voltage conversion sub-unit 11 of the current-to-full swing voltage conversion unit 10. The output signal (V_{O} ± DELTA V) from the current-to-small swing voltage conversion sub-unit is applied to the small swing voltage-to-full swing voltage conversion subunit 12, sub-unit 12 providing the output signal V_{OUT} (0->V_{DD}) for the non-differential, current mode data path. This signal V_{OUT} is applied to buffer unit 9. For storing data in the storage cell array 6, buffer unit 9 applies signals through data line transmitter 8 to the data line 2. The signals transmitted by the data line 2 are applied through data line receiver unit 7 to the LOCAL I/O signal terminal and the LOCAL I/O_ signal terminals to the storage cell array 6.

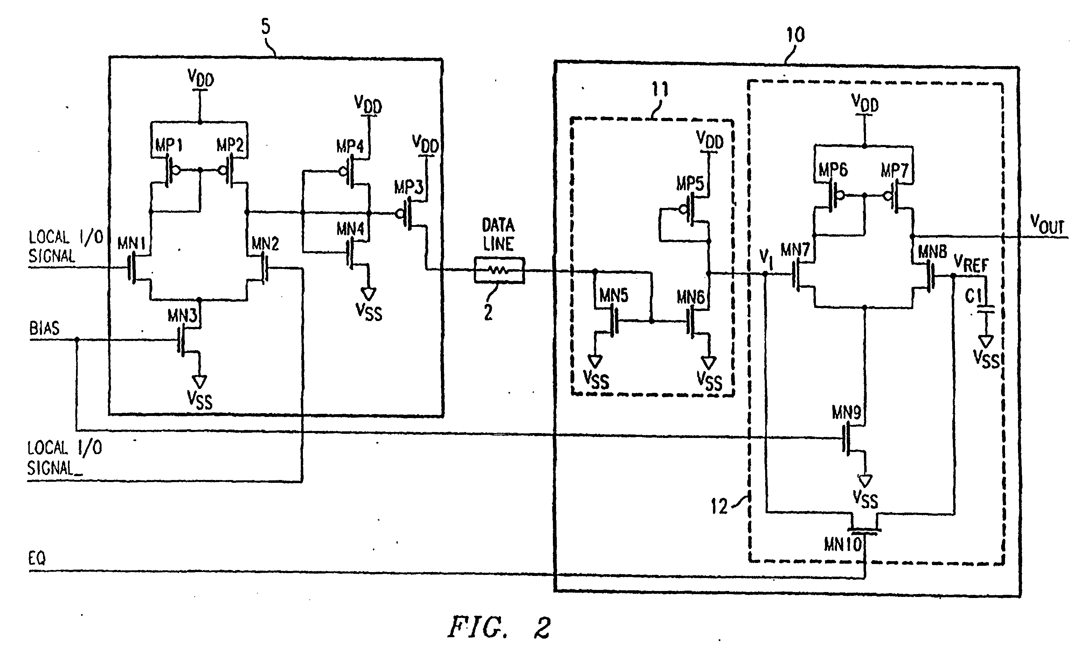

Referring to Fig. 2, a schematic diagram of the non-differential, current mode data path, according to the present invention, is shown. The LOCAL I/O SIGNAL is applied to a gate terminal of N-channel field effect transistor MN1, while the LOCAL I/O SIGNAL_ is applied to a gate terminal of N-channel field effect transistor MN2. The BIAS SIGNAL is applied to a gate terminal of n-channel field effect transistor MN3 and to a gate terminal of n-channel field effect transistor MN9, while a source terminal of transistor MN3 is coupled to supply terminal V_{SS}. A drain terminal of transistor MN3 is coupled to a source terminal of transistor MN1 and to a source terminal of transistor MN2. A drain terminal of transistor MN1 is coupled to a drain and a gate terminal of p-channel field effect transistor MP1 and to a gate terminal of p-channel field effect transistor MP2. The source terminal of transistor MP1 and the source terminal of transistor MP2 are coupled to supply terminal V_{DD}. The drain terminal of transistor MP2 is coupled to a drain terminal of transistor MN2, to a gate and drain terminal of p-channel field effect transistor MP4, to a gate and a drain terminal of n-channel field effect transistor MN4, and to a gate terminal of P-channel field effect transistor MP3. The source terminal of transistor MN4 is coupled to voltage supply terminal V_{SS}. The source terminal of transistor MP4 and the source terminal of transistor MP3 are coupled to the voltage supply terminal V_{DD}. The drain terminal of transistor MP3 is coupled through data line RES10 to a drain and a gate terminal of n-channel field effect transistor MN5 and to a gate terminal of n-channel field effect transistor MN6. The data line RES10 has both distributed resistance and distributed capacitance associated therewith. The source terminal transistor MN5 and the drain terminal of transistor MN6 are coupled to the voltage supply terminal V_{SS}. A drain terminal of transistor MN6 is coupled to a drain and a gate terminal of p-channel transistor MP5, to a gate terminal of transistor of n-channel field effect transistor MN7, and to a drain terminal of n-channel field effect transistor MN10. The source terminal of transistor MP5 is coupled to the voltage supply terminal V_{DD}. A drain terminal of transistor MN7 is coupled to a drain terminal and a gate terminal of p-channel field effect transistor MP6 and to a gate terminal of p-channel transistor field effect transistor MP7. A source terminal of transistor MP6 and a source terminal of transistor MP7 are coupled to the voltage supply terminal V_{DD}. A source terminal of transistor MN7 is coupled to a drain terminal of transistor MN9 and a source terminal of n-channel field effect transistor MN8. A source terminal of transistor MN9 is coupled to the voltage supply terminal V_{SS}. A gate terminal of transistor MN10 is coupled to an EQ SIGNAL. A source terminal of transistor MN10 is coupled to a gate terminal of transistor MN8 and through capacitor C1 to the voltage supply terminal V_{SS}. A drain terminal of transistor MN8 and a drain terminal of transistor MP7 are coupled to the output terminal.

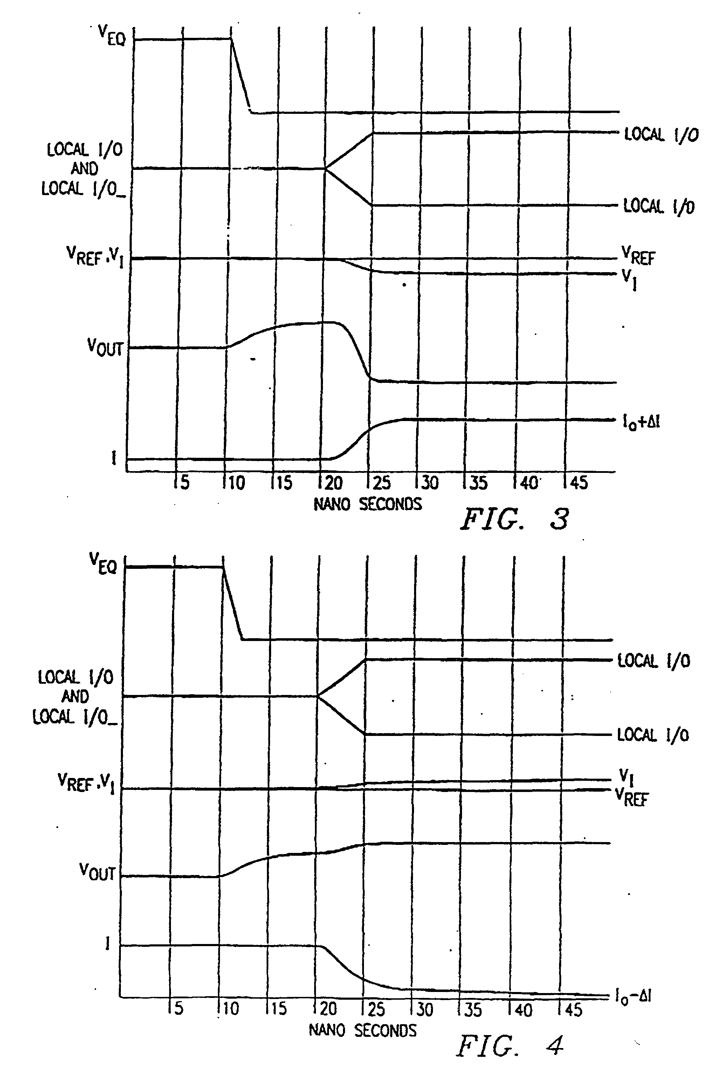

Referring to Figs. 3 and 4, simulated waveforms for the READ '0' transition (i.e., LOCAL I/O SIGNAL -> low, LOCAL I/O SIGNAL_ -> high) and the READ '1' (LOCAL I/O SIGNAL -> high, LOCAL I/O SIGNAL_ -> low), respectively are shown. During the first 20 nanoseconds, the voltage V₁ (i.e., the voltage applied to the gate terminal of transistor MN7) and the voltage V_{REF} (i.e., the voltage applied to the gate of transistor MN8) are equalized. After the equalization period, then the data read, '0' in Fig. 3 and '1' in Fig. 4, is initiated.

### OPERATION OF THE PREFERRED EMBODIMENTS

The general concept of the present non-differential, current mode data path is shown in Fig. 1. The LOCAL I/O SIGNALS (and their complements) are conventional full swing differential signals originating from sense amplifiers. These differential input signals are converted to non-differential, current mode signals with an approximately constant voltage and a current swing of Iₒ ± DELTA I. Because the voltage swing is limited (ideally zero), the capacitance of the data line has little effect on the propagation delay. At the receiver end of the data line, the current mode signal is converted to a full swing CMOS output signal level suitable for use by the coupled circuitry. The current-to-full swing conversion is accomplished in practice in two increments. The first increment converts the current swing to a small swing voltage signal Vₒ ± DELTA V. This small swing voltage signal is then converted to a full swing CMOS level by the second stage.

The implementation of the non-differential, current mode data line, according to the present invention is shown in Fig. 2. The differential voltage of the LOCAL I/O SIGNALS is converted to a signal voltage output using a differential amplifier (i.e., transistors MP1-MP2 and MN1-MN3). The output of the differential amplifier drives the gate of transistor MP3, the transistor MP3 modulating the current through the data line. The voltage applied to the gate of transistor MP3 is limited by transistors MP4 and MN4 to ensure that the transistor MP3 remains in saturation. At the receiver end of the data line, a current mirror is formed by transistors MN5 and MN6. The mirrored current through MN6 is passed through a diode-connected transistor MP5, thereby creating a voltage swing at the gate of transistor MN7.

In the typical differential data line implementation, the conversion to a full voltage swing signal is easily accomplished because the differential voltage between the two lines is increasing either positively or negatively. For the non-differential situation, this conversion is more difficult because the voltage signal is swinging around the positive voltage. To perform the conversion in the preferred embodiment voltage applied to the gate of transistor MN7 should be compared to a reference voltage. In the preferred embodiment, the reference voltage is supplied by a sample and hold technique, i.e., sampling the initial voltage a the gate of MN7 during precharge and holding this sampled voltage during the data sense operation. This sampling process eliminates the potential problem of having a reference voltage that shifts independently of the operation point of the data path circuitry, a process which could result in a reduced operation margin.

The comparator consists of a differential amplifier formed by transistors MP6-MP7 and MN7-MN9. The small swing voltage at the gate of transistor MN7 is coupled to one end of the differential amplifier. The voltage at the gate of transistor MN8 is generated before the sensing begins by bringing the EQ SIGNAL high. The LOCAL I/O SIGNALS are equalized at this time and the voltage at the gate of transistor MN7 is therefore at the equilibrium center value. With the EQ SIGNAL high, transistor MN10 is on, a condition which equalizes the voltage applied to the gate of transistor MN7 and the voltage applied to the gate of transistor MN8 and charges the capacitor C1. When the EQ SIGNAL turned off, capacitor C1 maintains the gate voltage of transistor MN8 at the precharged level. Once the LOCAL I/O SIGNALs separate, the gate voltage at transistor MN7 either swings up or swings down from the initial value, the polarity of the swing depending on the sensed state. The voltage V_{OUT} therefore swing positively or negatively, accordingly. In practice, an inverter or latch unit would be the next stage to ensure that the full swing voltage level is maintained.

While the invention has been described with particular reference to the preferred embodiment, it will be understood by those skilled in the art that various changes may be made and equivalents substituted for elements of the preferred embodiment without departing from the invention. In addition, many modifications may be made to adapt a particular situation and material to a teaching of the present invention without departing from the essential teachings of the present invention.

As is evident from the foregoing discussion, certain aspects of the invention are not limited to the particular details of the examples illustrated, and it is therefore contemplated that other modifications and applications will occur to those skilled in the art. For example, certain control signals needed to activate and coordinate the memory unit are not shown. Similarly, in the implementation of the present invention, provision would have to be made to eliminate the current drain when the device is in a standby mode of operation. It is accordingly intended that the claims shall cover all modifications and applications as do not depart from the scope of the invention.

## Claims

1. Apparatus coupled to a data line (2) for receiving a differential signal and for generating a logic level output signal, said apparatus comprising:
a differential voltage-to-current conversion unit (5) for receiving a differential voltage signal and for applying a current signal(I + ΔI) to said data line; and
a current-to-full swing voltage conversion unit (10) for receiving said current signal from said data line (2) and for generating a full swing output voltage (Vₒᵤₜ).

2. The apparatus of Claim 1, wherein said current-to-full swing voltage conversion unit (10) comprises:
a current-to-small swing voltage conversion sub-unit (11) for receiving said current signal from said data line (2) and for generating a small swing voltage signal (Vₒ + ΔV) therefrom; and
a small swing voltage-to-full swing voltage conversion sub-unit (12) for receiving said small swing signal (Vₒ + ΔV) and for generating a full swing signal therefrom (Vₒᵤₜ).

3. The apparatus of Claim 2, wheren said small swing voltage-to-full swing voltage unit (12) comprises:
a comparator; and
a reference voltage apparatus for providing a reference voltage against which said small swing voltage can be compared.

4. The apparatus of Claim 3, wherein said reference voltage apparatus comprises a sample and hold circuit.

5. The apparatus of any preceding claim, wherein said differential signals are provided by sense amplifiers associated with a storage cell of a dynamic random access memory storage unit.

6. The apparatus of any of Claims 2 to 5, wherein said full swing signal is suitable for use with CMOS circuits associated with said dynamic random access storage unit.

7. The apparatus of any of Claims 3 to 6, wherein said comparator comprises a differential amplifier.

8. A method for providing a non-differential current mode data path, said method comprising:
converting differential output signals from sense amplifiers to a non-differential current mode signal;
applying said non-differential current mode signal to a data line;
converting said non-differential current mode signal transmitted by said data line to a small swing voltage signal; and
converting said small swing voltage signal to a full swing voltage signal.

9. The method of Claim 8, wherein converting said small swing voltage signal comprises:
comparing said small swing voltage signal to a reference voltage.

10. The method of claim 8 or Claim 9, wherein converting said small swing voltage comprises sampling said small swing voltage signal during a period when said sense amplifiers are not sensing a voltage level of storage cells, to provide said reference voltage.

11. The method of any of Claims 8 to 10, wherein converting the small swing voltage comprises storing a reference voltage.

12. The method of Claim 10 or Claim 11, wherein converting said small swing voltage comprises comparing said reference voltage with said small swing voltage.

## Patentansprüche

1. Vorrichtung, die an eine Datenleitung (2) angeschlossen ist, um ein differentielles Signal zu empfangen und um ein Ausgangssignal mit logischem Pegel zu erzeugen, wobei die Vorrichtung umfaßt:
eine differentielle Spannungs/Strom-Umsetzungseinheit (5), die ein differentielles Spannungssignal empfängt und an die Datenleitung ein Stromsignal (I + ΔI) anlegt; und
eine Strom/Vollausschlagspannung-Umsetzungseinheit (10), die das Stromsignal von der Datenleitung (2) empfängt und eine Vollausschlag-Ausgangsspannung (Vₒᵤₜ) erzeugt.

2. Vorrichtung nach Anspruch 1, bei der die Strom/Vollausschlagspannung-Umsetzungseinheit (10) umfaßt:
eine Strom/Niedrigausschlagspannung-Umsetzungsuntereinheit (11), die das Stromsignal von der Datenleitung (2) empfängt und hieraus ein Niedrigausschlag-Spannungssignal (V₀ + ΔV) erzeugt; und
eine Niedrigausschlagspannung/Vollausschlagspannung-Umsetzungsuntereinheit (12), die das Niedrigausschlagsignal (V₀ + ΔV) empfängt und hieraus ein Vollausschlagsignal (Vₒᵤₜ) erzeugt.

3. Vorrichtung nach Anspruch 2, bei der die Niedrigausschlagspannung/Vollausschlagspannung-Einheit (12) umfaßt:
einen Komparator; und
eine Referenzspannungsvorrichtung, die eine Referenzspannung bereitstellt, mit der die Niedrigausschlagspannung verglichen werden kann.

4. Vorrichtung nach Anspruch 3, bei der die Referenzspannungsvorrichtung eine Abtast-/Halteschaltung enthält.

5. Vorrichtung nach einem vorhergehenden Anspruch, bei der die differentiellen Signale durch Leseverstärker bereitgestellt werden, die einer Speicherzelle einer dynamischen Speichereinheit mit wahlfreiem Zugriff zugeordnet sind.

6. Vorrichtung nach einem der Ansprüche 2 bis 5, bei der das Vollausschlagsignal für die Verwendung mit CMOS-Schaltungen geeignet ist, die der dynamischen Speichereinheit mit wahlfreiem Zugriff zugeordnet sind.

7. Vorrichtung nach einem der Ansprüche 3 bis 6, bei der der Komparator einen Differenzverstärker umfaßt.

8. Verfahren zum Bereitstellen eines Datenweges in einer nicht differentiellen Strombetriebsart, wobei bei dem Verfahren:
differentielle Ausgangssignale von Leseverstärkern in ein nicht differentielles Strombetriebsart-Signal umgesetzt werden;
das nicht differentielle Strombetriebsart-Signal in eine Datenleitung eingegeben wird;
das nicht differentielle Strombetriebsart-Signal, das über die Datenleitung übertragen wird, in ein Niedrigausschlagspannung-Signal umgesetzt wird; und
das Niedrigausschlagspannung-Signal in ein Vollausschlagspannung-Signal umgesetzt wird.

9. Verfahren nach Anspruch 8, bei dem bei der Umsetzung des Niedrigausschlagspannung-Signals
das Niedrigausschlagspannung-Signal mit einer Referenzspannung verglichen wird.

10. Verfahren nach Anspruch 8 oder Anspruch 9, bei dem bei der Umsetzung der Niedrigausschlagspannung das Niedrigausschlagspannung-Signal während einer Periode, in der die Leseverstärker keinen Spannungspegel von Speicherzellen erfassen, abgetastet wird, um die Referenzspannung zu erzeugen.

11. Verfahren nach einem der Ansprüche 8 bis 10, bei dem bei der Umsetzung der Niedrigausschlagspannung eine Referenzspannung gespeichert wird.

12. Verfahren nach Anspruch 10 oder 11, bei dem bei der Umsetzung der Niedrigausschlagspannung die Referenzspannung mit der Niedrigausschlagspannung verglichen wird.

## Revendications

1. Dispositif couplé à une ligne de données (2) pour recevoir un signal différentiel et pour générer un signal de sortie de niveau logique, ledit dispositif comprenant :
une unité de conversion de tension différentielle en courant (5) pour recevoir un signal de tension différentielle et pour appliquer un signal de courant (I + ΔI) à ladite ligne de données ; et
une unité de conversion de courant en tension d'oscillation totale (10) pour recevoir ledit signal de courant de ladite ligne de données (2) et pour générer une tension de sortie d'oscillation totale (Vₒᵤₜ).

2. Dispositif selon la revendication 1, dans lequel ladite unité de conversion de courant en tension d'oscillation totale (10) comprend :
une sous-unité de conversion de courant en tension de faible oscillation (11) pour recevoir ledit signal de courant de ladite ligne de données (2) et pour générer un signal de tension de faible oscillation (V₀ + Δv) à partir de celui-ci ; et
une sous-unité de conversion de tension de faible oscillation en tension d'oscillation totale (12) pour recevoir ledit signal de faible oscillation (V₀ + Δv) et pour générer un signal d'oscillation totale (Vₒᵤₜ) à partir de celui-ci.

3. Dispositif selon la revendication 2, dans lequel ladite unité de conversion de tension de faible oscillation en tension d'oscillation totale (12) comprend :
un comparateur ; et
un dispositif de tension de référence pour fournir une tension de référence à laquelle ladite tension de faible oscillation peut être comparée.

4. Dispositif selon la revendication 3, dans lequel ledit dispositif de tension de référence comprend un circuit d'échantillonnage et de maintien.

5. Dispositif selon l'une quelconque des revendications précédentes, dans lequel lesdits signaux différentiels sont délivrés par des amplificateurs de lecture associés à une cellule de mémoire d'une unité de mémorisation à mémoire vive.

6. Dispositif selon l'une quelconque des revendications 2 à 5, dans lequel ledit signal d'oscillation totale est adapté pour être utilisé avec des circuits CMOS associés à ladite unité de mémorisation à mémoire vive.

7. Dispositif selon l'une quelconque des revendications 3 à 6, dans lequel ledit comparateur comprend un amplificateur différentiel.

8. Procédé pour réaliser un trajet de données en mode de courant non différentiel, ledit procédé comprenant :
la conversion de signaux de sortie différentiels provenant d'amplificateurs de lecture en un signal de mode de courant non différentiel ;
l'application dudit signal de mode de courant non différentiel à une ligne de données ;
la conversion dudit signal de mode de courant non différentiel transmis par ladite ligne de données en un signal de tension de faible oscillation ; et
la conversion dudit signal de tension de faible oscillation en un signal de tension d'oscillation totale.

9. Procédé selon la revendication 8, dans lequel la conversion dudit signal de tension de faible oscillation comprend :
la comparaison dudit signal de tension de faible oscillation à une tension de référence.

10. Procédé selon la revendication 8 ou la revendication 9, dans lequel la conversion de ladite tension de faible oscillation comprend l'échantillonnage dudit signal de tension de faible oscillation pendant une période où lesdits amplificateurs de lecture ne sont pas en train de détecter un niveau de tension de cellules de mémoire, afin de fournir ladite tension de référence.

11. Procédé selon l'une quelconque des revendications 8 à 10, dans lequel la conversion de la tension de faible oscillation comprend la mémorisation d'une tension de référence.

12. Procédé selon la revendication 10 ou la revendication 11, dans lequel la conversion de ladite tension de faible oscillation comprend la comparaison de ladite tension de référence avec ladite tension de faible oscillation.
